Europäisches Patentamt

European Patent Office

Office européen des brevets

(19)

(11) Veröffentlichungsnummer: **0 187 185 B1**

(12) **EUROPÄISCHE PATENTSCHRIFT**

(45) Veröffentlichungstag der Patentschrift: 09.10.91

(51) Int. Cl.⁵: **H04B 14/06**, H03M 7/32

(21) Anmeldenummer: 85104964.3

(22) Anmeldetag: 24.04.85

(54) **Anordnung zur Vermittlung von Deltamodulationssignalen.**

(30) Priorität: 20.12.84 CH 6062/84

(43) Veröffentlichungstag der Anmeldung:
16.07.86 Patentblatt 86/29

(45) Bekanntmachung des Hinweises auf die
Patenterteilung:
09.10.91 Patentblatt 91/41

(84) Benannte Vertragsstaaten:
AT CH DE LI

(56) Entgegenhaltungen:
CH-A- 656 036
DE-A- 3 033 871
US-A- 3 548 309

CABLES & TRANSMISSION, Band 32, Nr. 4,
Oktober 1978, Seiten 447-460, Paris, FR; J.-M.
GAUTHIER et al.: "Système transmic. I. Principes généraux présentation du système"

(73) Patentinhaber: SIEMENS-ALBIS AKTIENGE-
SELLSCHAFT
PV/Patente und Verträge Postfach
CH-8047 Zürich(CH)

(72) Erfinder: Hagger, Hansjost, Dr.
Tulpenstrasse 376
CH-5212 Hausen(CH)

**Beschreibung**

Die vorliegende Erfindung betrifft eine Anordnung zur Vermittlung von Deltamodulationssignalen gemäss dem Oberbegriff des Patentanspruches 1.

Zur Durchschaltung von Deltamodulationssignalen in PCM-Anlagen werden manchmal Delta/PCM-Umwandler eingesetzt, wie sie beispielsweise aus der DE-OS 21 58 549 bekannt sind. Derartige Umwandler sind jedoch relativ aufwendig.

Es ist daher Aufgabe der Erfindung, eine Anordnung zur Vermittlung von Deltamodulationssignalen mit Hilfe von PCM-Zeitmultiplex-Vermittlungsanlagen zu schaffen, die eines solchen Delta-PCM-Umwandlers nicht bedarf. Dies wird durch die im kennzeichnenden Teil des Patentanspruchs 1 angegebenen Massnahmen erreicht.

Vorteilhafte Ausgestaltungen der Erfindung sind in weiteren Ansprüchen angegeben.

Die Erfindung wird nachfolgend durch Beschreibung von Ausführungsbeispielen anhand von Zeichnungen näher erläutert. Es zeigt:

| | |
|---|---|
| Fig.1 | die schematische Darstellung einer Anordnung zur Durchschaltung von Deltamodulationssignalen in PCM-Anlagen mit je einem Delta/PCM- und einem PCM/Delta-Umsetzer nach der Erfindung, |
| Fig. 2 | das Blockschaltbild eines erfindungsgemässen Delta/PCM-Umsetzers, |
| Fig.3 und 4 | Diagramme zur Erläuterung der Arbeitsweise eines solchen Umsetzers, |
| Fig. 5 | das Blockschaltbild eines erfindungsgemässen PCM/Delta-Umsetzers. |

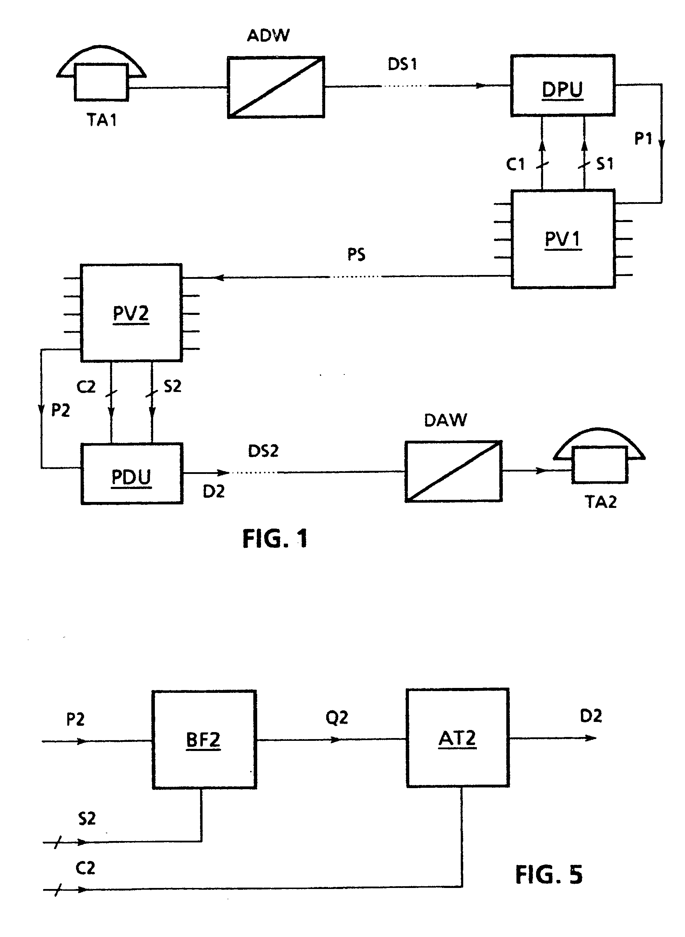

Die Anordnung nach Fig. 1 weist zwei untereinander über eine PCM-Strecke PS verbundene PCM-Vermittler PV1 und PV2 auf. Eine erste Telefonstation TA1 ist über die Reihenschaltung eines Analog/Delta-Wandlers ADW, einer Leitung DS1 für Deltamodulationssignale und eines Delta/PCM-Umsetzers DPU mit einem der empfangsseitigen Anschlüsse des Vermittlers PV1 verbunden. Zwischen einem der sendeseitigen Anschlüsse des Vermittlers PV2 und einer zweiten Telefonstation TA2 ist die Reihenschaltung eines PCM/Delta-Umsetzers PDU, einer Leitung DS2 für Deltamodulationssignale und eines Delta/Analog-Wandlers DAW eingefügt. Zur Vereinfachung sind in Fig. 1 nur jene Elemente dargestellt, die einen Datenfluss von der Telefonstation TA1 zur Station TA2 ermöglichen. In Wirklichkeit können jedoch die verschiedenen Elemente derart ausgestaltet sein, dass die Daten in beiden Richtungen übertragen werden.

Die Anordnung nach Fig. 1 funktioniert folgendermassen:

Der PCM-Vermittler PV1 versorgt den Umsetzer DPU mit verschiedenen Taktsignalen C1, S1. Das Gleiche geschieht mit dem Umsetzer PDU und dem Vermittler PV2, der weitere Taktsignale C2, S2 liefert. Die von der Telefonstation TA1 ankommenden analogen Signale im Frequenzbereich von 300 bis 3400 Hz werden durch den Wandler ADW in Deltamodulationssignale mit einer Datenrate von 16 oder 32 kBit/s umgewandelt, die über die Leitung DS1 zum Umsetzer DPU gelangen, wo daraus eine Pseudo-PCM-Signalfolge P1 von 64 kBit/s gebildet wird. Im PCM-Vermittler PV1 wird die Pseudo-PCM-Signalfolge P1 multiplexiert und auf den PCM-Vermittler PV2 weitergeleitet, der sie dann demultiplexiert. Der nachgeschaltete Umsetzer PDU wandelt die demultiplexierte Pseudo-PCM-Signalfolge von 64 kBit/s in Deltamodulationssignale D2 mit einer Bitrate von 16 oder 32 kBit/s um, die über den Wandler DAW als analoges Signal zur Telefonstation TA2 gelangen.

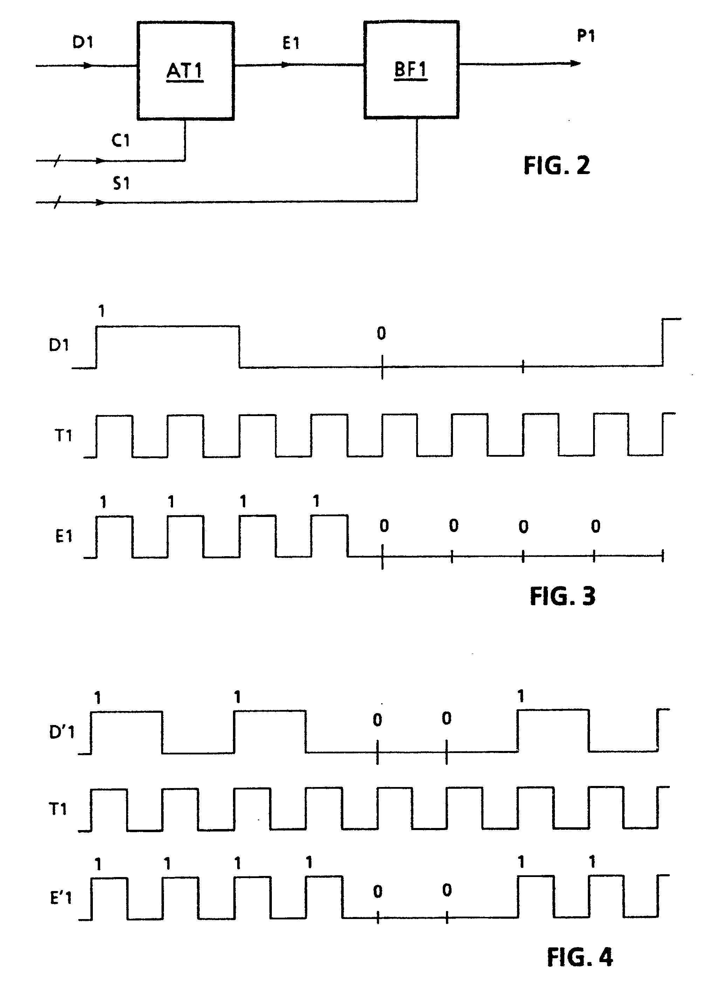

Der Delta/PCM-Umsetzer DPU nach Fig. 2 weist einen Abtaster AT1 und eine ihm nachgeschaltete Pufferschaltung BF1 auf. Der Abtaster AT1 wird über seinen Dateneingang mit Deltamodulationssignalen D1 sowie über seine Takteingänge mit verschiedenen Taktsignalen C1 beaufschlagt, worunter sich insbesondere ein Taktsignal T1 beispielsweise von 64 kHz (Fig. 3 und 4) befinden kann. Der Abtaster AT1 funktioniert in der Weise, dass er die Eingangssignale D1, die eine Bitrate von 16 kBit/s (Fig. 3) aufweisen, in Ausgangssignale E1 von 64 kBit/s umwandelt, bei denen jeweils jedes Bit der Bitfolge D1 in der Bitfolge E1 viermal nacheinander wiederholt wird (Fig. 3). Nach einer anderen Variante kann der Abtaster AT1 ein Eingangssignal D'1, das eine Bitrate von 32 kBit/s (Fig. 4) aufweist, in Ausgangssignale E'1 (Fig. 4) mit einer Bitrate von 64 kBit/s umwandeln, bei denen jedes Bit der Bitfolge D'1 in der Bitfolge E'2 zweimal nacheinander wiederholt wird.

Die Pufferschaltung BF1 bewirkt eine zeitliche Verschiebung des Signals E1 bzw. E'1, was von Bedeutung sein kann, wenn die Deltamodulationssignale D1 vor dem Abtaster AT1 demultiplexiert und/oder die Ausgangssignale P1 nach der Pufferschaltung BF1 in PCM-Kanälen multiplexiert werden müssen. Unter Umständen kann daher die Pufferschaltung BF1 entfallen, z.B. wenn der Vermittler PV1 die Funktion des Vermittlers PV2 übernimmt und die Strecke PS entfällt.

Der PCM-Delta-Umsetzer PDU nach Fig.5 weist eine Pufferschaltung BF2 und einen ihr nachgeschalteten Abtaster AT2 auf. Die Pufferschaltung BF2 bewirkt eine zeitliche Verschiebung des Signals P2, das der Form des Signals E1 (Fig.3) oder E'1 (Fig.4) entpricht. Dies kann von Bedeutung sein, wenn das Pseudo-PCM-Signal P2 vor Eintritt in die Pufferschaltung BF2 demultiplexiert und/oder die Deltasignale D2 nach dem Abtaster AT2 multiplexiert werden müssen. In manchen Fällen kann daher die Pufferschaltung BF2 entfallen. Der Abtaster AT2 wird über seinen Dateneingang mit den Pseudo-PCM-Signalen Q2 sowie über seine Takteingänge mit verschiedenen Taktsignalen C2 beaufschlagt, worunter sich insbesondere ein Taktsignal beispielsweise von 64 kHz (= T1 in Fig. 3 und 4) befinden kann. Der Abtaster AT2 funktioniert in der Weise, dass er die Eingangssignale Q2 (= E1 in Fig.3) von 64 kBit/s, bei denen jeweils viermal nacheinander ein Bit derselben Wertigkeit ankommt, in Ausgangssignale D2 (= D1 in Fig.3) von 16 kBit/s umwandelt. Nach der anderen Variante können die zwei nacheinander ankommenden Bit (= E'1 in Fig.4) auf jeweils ein Bit (= D'1 in Fig.4) reduziert werden.

Schliesslich sei noch bemerkt, dass der Delta-PCM-Umsetzer die einzelnen Bits XYZ . . . der Deltamodulationssignale D1 oder D'1 allgemein in eine Pseudo-PCM-Signalfolge der Form X'n Y'n Z'n . . . transformieren kann, worin X'n, Y'n, Z'n, . . . jeweils eine n Bit-Stellen aufweisende Funktion der einzelnen Bits X, Y, Z, ... der Deltamodulationssignalfolge ist, und wobei diese Signalfolge eine Bitrate von n $\cdot$ N kBit/s aufweist, wenn N die Bitrate der Deltamodulationssignale ist. Zum Beispiel könnte aus XYZ ... = 1 0 1 . . . auch die Folge /1010/0101/1010/ ... abgeleitet werden, wobei wegen der Redundanz auch gewisse Bits unbestimmt sein dürfen, wie es in der Folge /11u1/0v00/11u1/ ... der Fall ist, worin u und v gleich 0 oder 1 sein können.

## Patentansprüche

1. Anordnung zur Vermittlung von Deltamodulationssignalen, die eine Bitrate von N kBit/s aufweisen, mit Hilfe mindestens einer PCM-Zeitmultiplex-Vermittlungsanlage, **dadurch gekennzeichnet,** dass mindestens ein Delta-PCM-Umsetzer (DPU) vorhanden ist, der eine Umwandlung der einzelnen Bits XYZ . . . der Deltamodulationssignale in eine Pseudo-PCM-Signalfolge der Form X'n Y'n Z'n . . . bewirkt, worin X'n, Y'n, Z'n, ... jeweils eine n Bit-Stellen aufweisende Funktion der einzelnen Bits X, Y, Z, . . . ist, und wobei diese Signalfolge eine Bitrate von n $\cdot$ N kBit/s aufweist, und dass mindestens ein PCM-Delta-Umsetzer (PDU) vorgesehen ist, in dem diese Pseudo-PCM-Signalfolge nach deren Durchschaltung über eine PCM-Zeitmultiplex-Vermittlungsanlage eine Rückumsetzung in die ursprüngliche Form XYZ . . . erfährt.

2. Anordnung nach Anspruch 1, **dadurch gekennzeichnet,** dass die Pseudo-PCM-Signale eine Form X..XY..YZ..Z aufweisen, worin die einzelnen Bits X, Y, Z, . . . jeweils n Mal wiederholt werden.

3. Anordnung nach Anspruch 1 oder 2, **dadurch gekennzeichnet,** dass die Deltamodulationssignale (D1) demultiplexiert werden, bevor sie in den Delta-PCM-Umsetzer (DPU) gelangen.

4. Anordnung nach einem der Ansprüche 1, 2 oder 3, **dadurch gekennzeichnet,** dass der Delta-PCM-Umsetzer (DPU) eine Pufferschaltung (BF1) umfasst, in der die Pseudo-PCM-Signale (P1) vor ihrer Durchschaltung vorübergehend gespeichert werden.

5. Anordnung nach Anspruch 1 oder 2, **dadurch gekennzeichnet,** dass nach der Rückumsetzung im PCM-Delta-Umsetzer (PDU) die Deltamodulationssignale (D2) multiplexiert werden.

6. Anordnung nach einem der Ansprüche 1, 2 oder 5, **dadurch gekennzeichnet,** dass der PCM-Delta-Umsetzer (PDU) eine Pufferschaltung (BF2) umfasst, in der die Pseudo-PCM-Signale (P2) vor deren Rückumsetzung vorübergehend gespeichert werden.

## Claims

1. Arrangement for switching delta-modulation signals which have a bit rate of N kbit/s, with the aid of at least one PCM-time-division multiplex-switching system, characterised in that there is at least one delta-PCM-converter (DPU) present which effects a conversion of the individual bits XYZ... of the delta-modulation signals into a pseudo-PCM-signal sequence of the form X'n Y'n Z'n..., in which X'n, Y'n, Z'n,... in each case is a function, having n bit positions, of the individual bits X, Y, Z,... and in which case this signal sequence has a bit rate of n $\cdot$ N kbit/s and in that there is provided at least one PCM-delta-converter (PDU) in which this pseudo-PCM-signal sequence after it has been switched through by way of a PCM-time-division multiplex-switching system undergoes a reconversion into the original form XYZ... .

2. Arrangement according to claim 1, characterised in that the pseudo-PCM-signals have a form X..XY..YZ..Z, in which the individual bits X, Y, Z,... are each repeated n times.

3. Arrangement according to claim 1 or 2, characterised in that the delta-modulation signals (D1) are demultiplexed before they reach the delta-PCM-converter (DPU).

4. Arrangement according to one of the claims 1, 2 or 3, characterised in that the delta-PCM-converter (DPU) comprises a buffer circuit (BF1) in which the pseudo-PCM-signals (P1) are temporarily stored before they are switched through.

5. Arrangement according to claim 1 or 2, characterised in that the delta-modulation signals (D2) are multiplexed after the reconversion in the PCM-delta-converter (PDU).

6. Arrangement according to one of the claims 1, 2 or 5, characterised in that the PCM-delta-converter (PDU) comprises a buffer circuit (BF2) in which the pseudo-PCM-signals (P2) are temporarily stored before their re-conversion.

**Revendications**

1. Dispositif pour la commutation de signaux à modulation delta, qui présentent un débit binaire de N k.bits/s, à l'aide d'au moins une installation de commutation à multiplexage temporel du type PCM, caractérisé par le fait qu'il comporte au moins un convertisseur delta-PCM (DPU) qui réalise une conversion des différents bits XYZ... des signaux à modulation delta en un train de signaux pseudo-PCM de la forme $X'_n Y'_n Z'_n$, dans lequel $X'_n$, $Y'_n$, $Z'_n$ ... représentent respectivement une fonction à n chiffres binaires des différents bits X,Y,Z, ledit train de signaux présentant un débit binaire de n.Nk.bits/s, et qu'il est prévu au moins un convertisseur PCM-delta (PDU), dans lequel ce train de signaux pseudo-PCM subit, après sa commutation par l'intermédiaire d'une installation de commutation à multiplexage temporel du type PCM, une inversion en la forme XYZ initiale.

2. Dispositif selon la revendication 1, caractérisé par le fait que les signaux pseudo-PCM se présentent sous une forme X..XY..YZ..Z, dans laquelle les différents bits X,Y,Z, ... sont chacun répétés n fois.

3. Dispositif selon la revendication 1 ou 2, caractérisé par le fait que les signaux de modulation delta (D1) sont démultiplexés avant de parvenir dans le convertisseur delta-PCM (DPU).

4. Dispositif selon l'une des revendications 1,2 ou 3, caractérisé par le fait que le convertisseur delta-PCM (DPU) comporte un circuit tampon (BF1), dans lequel sont mémorisés passagèrement les signaux pseudo-PCM (P1), avant leur commutation.

5. Dispositif selon la revendication 1 ou 2, caractérisé par le fait qu'après la reconversion dans le convertisseur PCM-delta (PDU), les signaux à modulation delta (D2) sont multiplexés.

6. Dispositif selon l'une des revendications 1, 2 ou 5, caractérisé par le fait que le convertisseur PCM-delta (PDU) comporte un circuit tampon (BF2) dans lequel les signaux pseudo-PCM (P2) sont mémorisés temporairement, avant leur reconversion.

**FIG. 1**

**FIG. 5**

D1 ──────→ ┌─────────┐ ──E1──→ ┌─────────┐ ──────→ P1
           │   AT1   │         │   BF1   │
           └─────────┘         └─────────┘

C1

S1

**FIG. 2**

**FIG. 3**

**FIG. 4**